# EUROPÄISCHE PATENTSCHRIFT

(11) **EP 1 067 831 B1**
(45) Veröffentlichungstag und Bekanntmachung des Hinweises auf die Patenterteilung: **18.06.2003**
(21) Anmeldenummer: 99112558.4
(22) Anmeldetag: 01.07.1999
(51) Int. Cl.: H05K 7/20, H02M 7/00

(54) **Halbleiter-Schaltungsanordnung, insbesondere Hochstromumrichter mit niedriger Zwischenkreisspannung**
Semiconductor switching device, particularly for high current inverter with low intermediate circuit voltage
Dispositif de commutation à semiconducteur, notamment pour onduleurs à courants forts avec circuit intermédiaire à faible tension

(43) Veröffentlichungstag der Anmeldung: 10.01.2001
(73) Patentinhaber: SIEMENS AKTIENGESELLSCHAFT, 80333 München (DE)
(72) Erfinder: Allwang, Reinhard, 92421 Schwandorf (DE)

(56) Entgegenhaltungen:
- WO-A-96/27942
- DE-C- 19 645 636
- US-A- 5 060 112
- US-A- 5 396 404
- US-A- 5 914 860

## Beschreibung

Die Erfindung bezieht sich auf eine Halbleiter-Schaltungsanordnung, insbesondere Hochstromumrichter mit niedriger Zwischenkreisspannung, gemäß Patentanspruch 1; derartige Schaltungsanordnungen sind insbesondere zum Einsatz in Kraftfahrzeugen zwischen zumindest einem batteriegestützten Niederspannungs-Bordnetz einerseits und einem Starter-Generator als Anlasser bzw. Lader für die jeweilige Batterie andererseits vorgesehen. Sie dienen im Schubbetrieb des Kraftfahrzeuges zur Anpassung von Spannung und Leistung des dann als Generator arbeitenden Starter-Generators an die entsprechenden Betriebsdaten der jeweiligen nachzuladenden Batterie und beim Starten des dann als Motor arbeitenden Starter-Generators mit Hilfe der jeweiligen Batterie zur Gewährleistung eines hinreichenden Start-Drehmomentes mit entsprechend hohem Anfahrstrom.

Als wesentliche Bauteile einer solchen Schaltungsanordnung gelten insbesondere eine Anzahl von Halbleiter-Halbbrücken als Leistungs-Bauelemente, eine Anzahl von Zwischenkreis-Bauelementen, insbesondere Kondensatoren, und eine Anzahl von Steuerelementen, insbesondere Treiberstufen.

Aus der DE 196 45 636 C1 ist eine Halbleiter-Schaltungsanordnung zur Ansteuerung eines Elektromotors bekannt, bei der eine Leistungseinheit mit elektronischen Halbleitern auf der Oberseite eines DCB-Substrats und in dessen Ebene angeordnet und kontaktiert ist, das mit seiner Unterseite unmittelbar auf der Oberfläche einer Kühlereinheit aufliegt; parallel und beabstandet liegt oberhalb des DCB-Substrats eine Trägerplatte, auf deren Oberseite und Unterseite Halbleiter-Bauelemente einer zugehörigen Ansteuereinheit gehaltert und kontaktiert, insbesondere verlötet, sind. Senkrechte, mit dem DCB-Substrat verlötete Kontaktstifte dienen der Kontaktierung zwischen der Leistungseinheit auf dem DCB-Substrat einerseits und der Ansteuereinheit auf der Trägerplatte andererseits. Parallel zu dem DCB-Substrat und der Trägerplatte führen Gleichspannungs-Stromschienen durch einen Gehäusekörper nach außen zu dort auf der Oberseite der Kühlereinheit gelagerte Zwischenkreis-Kondensatoren; Anschlußschienen zur Wechsel- bzw. Drehstromseite der Schaltungsanordnung sind senkrecht zum DCB-Substrat und zur Trägerplatte aus dem Gehäusekörper nach außen geführt.

Durch die US 5 060 112 A ist eine Halbleiter-Schaltungsanordnung mit einer beidseitig mit passiven und aktiven Bauelementen bestückten Leiterplatte und einer dazu unterhalb in parallelem Abstand angeordneten Haupt-Kühlfläche bekannt, wobei im Zwischenraum zwischen der Leiterplatte und der Kühlfläche angeordnete Leistungsbauelemente mit ihren Kühlflächen durch seitlich parallel zur Hauptkühlfläche eingeschobene Druckstücke über Federelemente gegen senkrecht einstückige Wände eines auf der Kühlfläche aufliegenden Wärmeleitstückes angedrückt werden.

Gemäß Aufgabe vorliegender Erfindung soll bei fertigungstechnisch einfachem Aufbau ein niederinduktiver temperaturwechselbeständiger Hochstrom-Umrichter, insbesondere Hochstrom-Umrichter mit niedriger Zwischenkreisspannung, höchster Kompaktheit geschaffen werden.

Die Lösung dieser Aufgabe gelingt erfindungsgemäß durch eine Halbleiter-Schaltungsanordnung gemäß Patentanspruch 1; vorteilhafte Ausgestaltungen der Erfindung sind jeweils Gegenstand der Unteransprüche.

Die erfindungsgemäß vorgesehenen Leistungs-Bauelemente sind z.B. als Single Mosfets mit "Silicon chip on Direct-Copper-Bond aluminium nitride substrate" der Firma IXYS bekannt.

Die Verwendung von diskreten aktiven Leistungs-Bauelementen mit integrierter rückseitiger Einzel-Kühlfläche und deren abgewinkelte Anordnung im Abstandsraum zwischen der Zwischenkreis-Leiterplatte einerseits und der Hauptkühlfläche andererseits erlaubt bei guter Kühlmöglichkeit auch den niederinduktiven Einbau der Zwischenkreis-Bauelemente innerhalb des Abstandsraums bei gleichzeitig hinsichtlich Fertigung und Service vorteilhafter Kontaktierungsmöglichkeit der Leistungs-Bauelemente als auch der Zwischenkreis-Bauelemente mit der den Abstandsraum begrenzenden Zwischenkreis-Leiterplatte. Zur einfachen und trotzdem wirksamen Wärmeableitung zwischen den Einzel-Kühlflächen der diskreten Leistungs-Bauelemente sind senkrecht zur Haupt-Kühlfläche montierbare Wärmeleitstücke zwischen einerseits der Unterseite der Einzel-Kühlflächen der mit ihren Kontaktierungsbeinen nach oben gegen die Zwischenkreis-Leiterplatte zeigenden Leistungs-Bauelemente und andererseits der Haupt-Kühlfläche mit mittelbarer bzw. unmittelbarer Anlage angeordnet. Zur Verbesserung des Wärmeübergangs und gleichzeitig der vibrationsfesteren Halterung der Leistungs-Bauelemente sind Andruckstücke vorgesehen, mit denen die Leistungs-Bauelemente ebenfalls in axialer Aufbaumontage in Druckrichtung senkrecht zu der Haupt-Kühlfläche mit ihren Einzel-Kühlflächen gegen das Wärmeleitstück andrückbar sind.

Bei zweckmäßigerweise vorgesehener Reihenanordnung, vorzugsweise mit in V-Form gegenüberstehenden Reihen, der diskreten Leistungs-Bauelemente, ist ein entsprechendes blockartiges Wärmeleitstück mit oberseitiger V-förmiger Aufnahmewanne vorgesehen, so daß jeweils zwei einander gegenüberstehende Reihenanordnungen gleichzeitig aufnehmbar sind. Zweckmäßigerweise greift dann ein blockartiges Andruckstück mit V-förmiger Spitze von oben in die V-förmig geöffneten Schenkel der in Reihen zueinander angeordneten Leistungs-Bauelemente. Zum einfachen Toleranzausgleich zwischen der Anlagefläche des Andruckstückes und den Anlageflächen der Leistungs-Bauelemente dient eine elastische erste Zwischenschicht, z.B. eine Elastomer-Zwischenschicht.

Zur weiteren Erhöhung der, insbesondere bei Einsatz in einem Kraftfahrzeug, vorteilhaften hohen Vibrationsfestigkeit ist nach einer Ausgestaltung der Erfindung auch eine gegenseitig fixierende, zweckmäßigerweise gleichzeitig gut wärmeleitende, insbesondere zwischengegossene zweite Zwischenschicht zwischen den der Zwischenkreis-Leiterplatte abgewandten freien Enden der Zwischenkreis-Bauelemente einerseits und der zugewandten Haupt-Kühlfläche bzw. einer mit dieser in Verbindung stehenden Befestigungsplatte andererseits vorgesehen.

Die Erfindung sowie weitere vorteilhafte Ausgestaltungen der Erfindung gemäß Merkmalen der Unteransprüche werden im folgenden anhand eines Ausführungsbeispiels in der Zeichnung näher erläutert, darin zeigen:

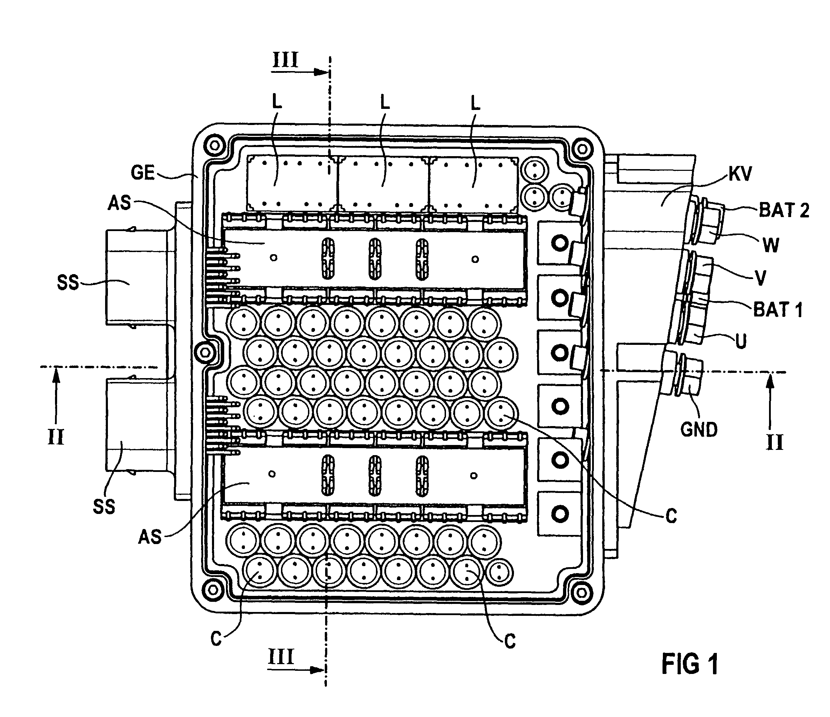

- FIG 1: eine Oberansicht der Halbleiter-Schaltungsanordnung bei noch nicht montierten Teilen wie dem oberen Gehäuse-Deckel, einer Steuer-Leiterplatte und einer Zwischenkreis-Leiterplatte;
- FIG 2: die Halbleiter-Schaltungsanordnung gemäß FIG 1 im Schnittverlauf II-II und mit bereits montierten Teilen wie dem oberen Gehäuse-Deckel, einer Steuer-Leiterplatte und einer Zwischenkreis-Leiterplatte;
- FIG 3: die Halbleiter-Schaltungsanordnung gemäß FIG 1 im Schnittverlauf III-III und mit bereits montierten Teilen wie dem oberen Gehäuse-Deckel, einer Steuer-Leiterplatte und einer Zwischenkreis-Leiterplatte;
- FIG 4: eine Ausschnittsvergrößerung aus FIG 3 im Bereich von in gegenseitiger V-Form fixierten Reihenanordnungen von Leistungs-Bauelementen.

In einem Gehäuse GE mit einem oberen Abschlußdeckel D1 und einem unteren, auf einer Haupt-Kühlfäche KF eines Kühlers K aufliegenden Abschlußdeckels D2 sind in einem Abstandsraum A zwischen dem unteren Abschlußdeckel D2 und der dazu im wesentlichen parallel im Abstand angeordneten Zwischenkreis-Leiterplatte ZP, insbesondere einer Multilayer-Leiterplatte, Zwischhenkreis-Bauelemente C;L in Form von Zwischenkreis-Kondensatoren C und Zwischenkreis-Induktivitäten L sowie Leistungs-Bauelemente T in Form von diskreten Transistoren mit jeweils integrierter elektrisch isolierter rückseitiger Einzel-Kühlfläche TF angeordnet.

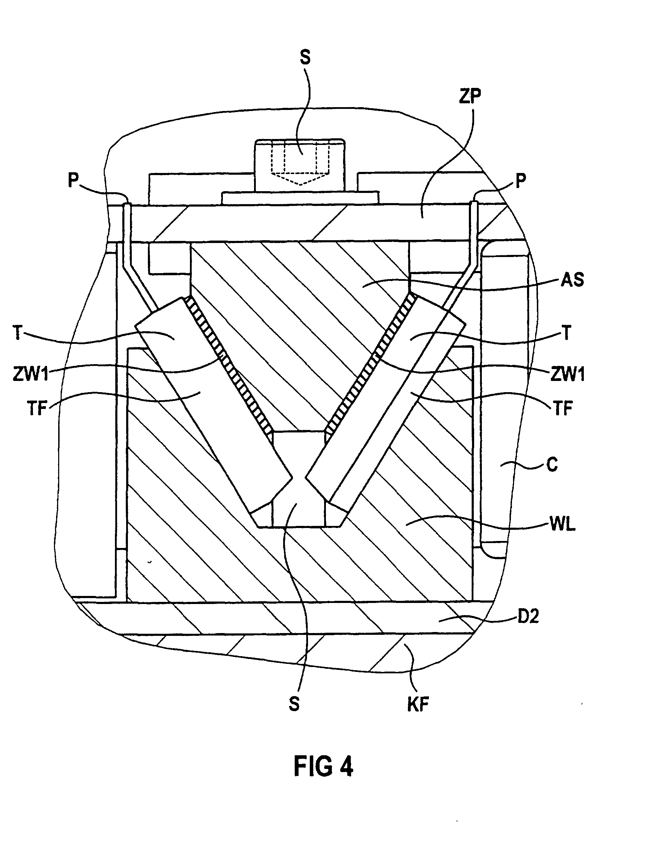

Im Sinne einer hohen Kompaktheit und somit optimaler Ausnutzung des Abstandsraums zur Unterbringung der Zwischenkreis-Bauelemente C;L sowie der Leistungs-Bauelemente T sind die Leistungs-Bauelemente T - wie insbesondere aus der Ausschnittsvergrößerung gemäß FIG 4 ersichtlich - abgewinkelt zu der Haupt-Kühlfäche KF bzw. einer dazu zu guter Wärmeableitung stehenden Befestigungsplatte, z.B. in Form des unteren Abschlußdeckels D2, hochgestellt, insbesondere in jeweils, V-förmig zueinander parallelen Reihenanordnungen mit zur Zwischenkreis-Leiterplatte ZP gerichteter Schenkelöffnung.

In für eine Fertigung sowie Servicebetreuung vorteilhafter Weise sind die Zwischenkreis-Bauelemente C;L sowie die Leistungsbauelemente T derart angeordnet, daß sie mit ihren Kontaktierungsenden P in Form von sogenannten Pins direkt mit der Zwischenkreis-Leiterplatte ZP kontaktierbar sind, insbesondere durch Tauch- bzw. Schwalllöten der durch die Zwischenkreis-Leiterplatte ZP hindurch bis zu entsprechenden Kontaktbahnen auf deren Oberfläche durchgesteckten Kontaktierungsenden P. In einer weiteren Ebene ist vorzugsweise parallel und oberhalb zur Zwischenkreis-Leiterplatte ZP eine Ansteuer-Leiterplatte SP angeordnet. Die derart mit den Zwischenkreis-Bauelementen C;L und den Leistungs-Bauelementen T bestückbare Zwischenkreis-Leiterplatte ZP wird zweckmäßigerweise als Vormontageeinheit gefertigt und dann im Gehäuse GE montiert und fixiert.

Zur Fixierung der Leistungs-Bauelmente T und gleichzeitig guten Wärmeableitung zwischen den Einzel-Kühlfächen TF der Leistungs-Bauelemente T einerseits und der Haupt-Kühlfläche KF des Kühlers K andererseits dienen Wärmeleitstücke WL, die zweckmäßigerweise blockartig jeweils zwei in V-Form angeordnete Reihen von Leistungs-Bauelementen T mit einer der Spitze der V-förmigen Anordnung angepaßten wannenförmigen Aufnahme umfassen.

Nach einer weiteren Ausgestaltung der Erfindung werden die Leistungs-Bauelemente T mittels eines Andruckstückes AS gegen das Wärmeleitstück WL angedrückt; zweckmäßigerweise sind ähnlich wie bei dem zuvor beschriebenen Wärmeleitstücke WL wiederum blockartige Andruckstrücke AS vorgesehen, die jeweils zwei in V-Form angeordnete Reihen von Leistungs-Bauelementen T andrücken und dazu mit einer V-förmigen Spitze in die Schenkelöffnung der V-förmigen Reihenanordnung einsteckbar sind und gegen die Oberseite der Leistungs-Bauelemente T andrücken. Zum Toleranzausgleich ist zwischen den Andruckflächen der Andrückstücke AS einerseits und der Oberseite der Leistungs-Bauelemente T andererseits eine elastische erste Zwischenschicht ZW1, insbesondere eine Elastomer-Zwischenschicht, vorgesehen.

Die gegenseitige Fixierung der Zwischenkreis-Leiterplatte ZP mit den daran kontaktierten Zwischenkreis-Bauelementen C;L und Leistungs-Bauelementen T mit deren gleichzeitigem Andruck über die Andruckstücke AS und die Wärmeleitstücke WL an den unteren Abschlußdeckel D2 erfolgt nach einer Ausgestaltung der Erfindung mittels Schrauben S, die mit ihrem Schraubenkopf auf der Zwischenkreis-Leiterplatte ZP aufliegen, durch die Andrückstücke und das Wärmeleitstück WL zwischen den Leistungs-Bauelementen T hindurchragen und - in hier nicht näher dargestellter Weise - in den unteren Gehäusedeckel D2 einschraubbar sind; alternativ dazu kann auch eine Verschraubung der Schrauben S mit dem Wärmeleitstück WL erfolgen, das seinerseits über andere Befestigungsmittel bei gleichzeitig guter Wärmeleitung an dem unteren Gehäusedeckel D2 fixierbar ist. Zur besonders vibrationsfesten Fixierung der toleranzbehafteten Zwischenkreis-Baulemente C;L gegenüber dem unteren Abschlußdeckel D2 ist nach einer weiteren Ausgestaltung der Erfindung gegebenenfalls zwischen den unteren freien Enden der Zwischenkreis-Bauelemente C;L und dem unteren Abschlußdeckel D2 eine wärmeleitende zweite Zwischenschicht ZW2, insbesondere eine gegossene Zwischenschicht, vorgesehen.

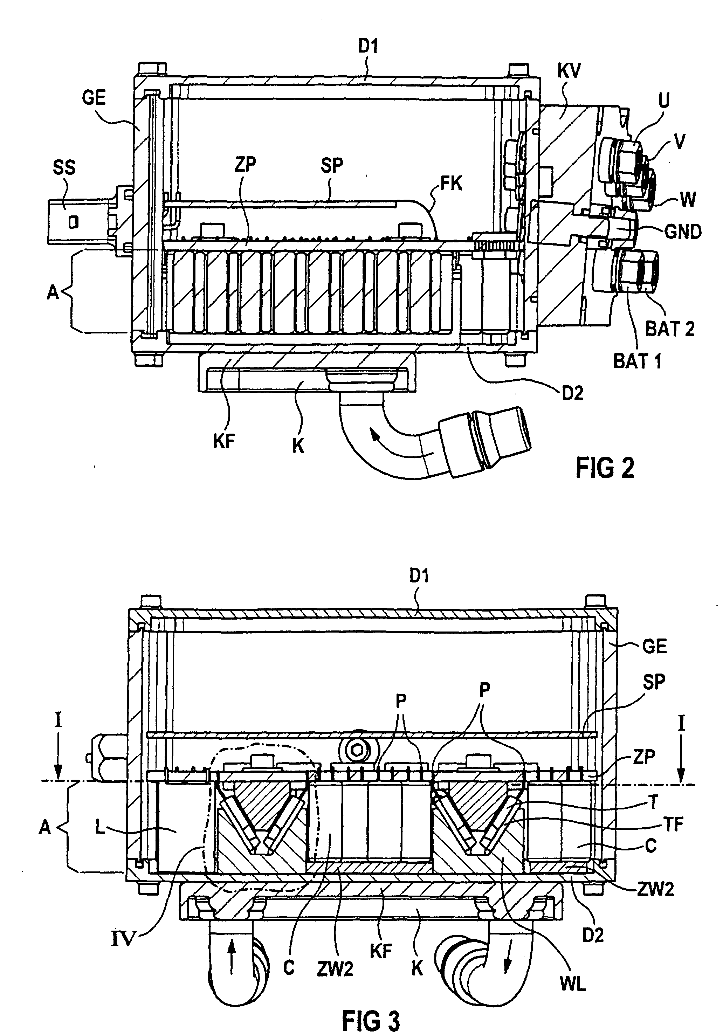

Die oberhalb der Zwischenkreis-Leiterplatte ZP in einer weiteren Ebene angeordnete Ansteuer-Leiterplatte SP ist hier über ein Flachbandkabel FK mit den anzusteuernden Leistungsbauteilen der Zwischenkreis-Leiterplatte ZP verbunden. Für eine besonders einfache und nur kurze Leitungswege erfordernde Anschlußmöglichkeit der Wechsel- bzw. Drehstromseite eines z.B. hier von der erfindungsgemäßen Halbleiter-Schaltungsanordnung versorgten Starter-Generators in einem Kraftfahrzeug bzw. der Gleichstromseite von einer oder mehrerer fahrzeugseitigen Batterien sind entsprechende Wechsel- bzw. Drehstromanschlüsse U;V;W des Starter-Generators einerseits und Gleichstromanschlüsse BATT1;BATT2;GND andererseits - wie insbesondere aus FIG 2 ersichtlich - in einem Kontaktverbindungsblock KV an der einen Gehäuseseite des Gehäuses GE vorgesehen. Auf der anderen Gehäuseseite des Gehäuses GE ist ein mit der Ansteuer-Leiterplatte SP innerhalb des Gehäuses GE kontaktierter Signalstecker SS zur Zuführung äußerer Ansteuersignale bzw. Herausführung innerer Signalgrößen vorgesehen.

Die erfindungsgemäße Halbleiter-Schaltungsanordnung gewährleistet bei einfachster Fertigungstechnik, insbesondere hinsichtlich einer für einen Hochstromumrichter mit niedriger Zwischenkreis-Spannung vorteilhafter niederinduktiven Anordnung der einzelnen Komponente der Bestückung und deren Kontaktierung untereinander, eine hinreichenden Entwärmung trotz der für einen Einsatz in einem Kraftfahrzeug besonders vorteilhaften, möglichen kompakten Bauweise.

## Patentansprüche

1. Halbleiter-Schaltungsanordnung, insbesondere Hochstromumrichter mit niedriger Zwischenkreisspannung, enthaltend:
- eine Zwischenkreis-Leiterplatte (ZP), insbesondere eine Multilayer-Leiterplatte;
- eine Haupt-Kühlfläche (KF) in parallelem Abstand zu der Zwischenkreis-Leiterplatte (ZP);
- passive Zwischenkreis-Bauelemente (C;L) und aktive diskrete Leistungs-Bauelemente (T) mit integrierter rückseitiger Einzel-Kühlfläche (TF) ;
- eine Anordnung der passiven Zwischenkreis-Bauelemente (C;L) und der aktiven diskreten Leistungs-Bauelemente (T) im Abstandsraum (A) zwischen der Zwischenkreis-Leiterplatte (ZP) und der Haupt-Kühlfläche (KF);
- eine Anordnung der Zwischenkreis-Bauelemente (C;L) und/oder der Leistungs-Bauelemente (T) mit gegen die Zwischenkreis-Leiterplatte (ZP) gerichteten und mit dieser kontaktierten Kontaktierungsenden (P);
- eine Anordnung der Leistungs-Bauelemente (T) im Sinne einer zu der Haupt-Kühlfäche (KF) jeweils schräggestellt angewinkelter Einzel-Kühlfläche (TF);
- eine Wärmeübertragung zumindest zwischen den Einzel-Kühlfächen (TF) einerseits und der Haupt-Kühlfläche (KF) andererseits über ein in Wärmeleitkontakt mit den Einzel-Kühlflächen (TF) und der Haupt-Kühlfläche (KF) stehendes Wärmeleitstück (WL);
- ein Andruckstück (AS), mit dem die Leistungs-Bauelemente (T) mit ihrer Einzel-Kühlfläche (TF) in Druckrichtung senkrecht zu der Haupt-Kühlfläche (KF) gegen das Wärmeleitstück (WL) andrückbar sind.

2. Halbleiter-Schaltungsanordnung nach Anspruch 1, enthaltend:
- eine elektrische Kontaktierung der Zwischenkreis-Bauelemente (C;L) und/oder der Leistungs-Bauelemente (T) mit der Zwischenkreis-Leiterplatte (ZP) an deren dem Abstandsraum (A) abgewandten Oberfläche.

3. Halbleiter-Schaltungsanordnung nach Anspruch 1 und/oder 2, enthaltend:
- eine Anordnung der Zwischenkreis-Leiterplatte (ZP) oberhalb der Haupt-Kühlfläche (KF).

4. Halbleiter-Schaltungsanordnung nach zumindest einem der Ansprüche 1-3, enthaltend:
- eine wechselweise reihenförmige Anordnung der Zwischenkreis-Bauelemente (C;L) einerseits bzw. der Leistungs-Bauelemente (T) andererseits in dem Abstandsraum (A) zwischen der Zwischenkreis-Leiterplatte (ZP) bzw. der Haupt-Kühlfläche (KF).

5. Halbleiter-Schaltungsanordnung nach zumindest einem der Ansprüche 1-4, enthaltend:
- eine Anordnung von jeweils zwei V-förmig zueinander angeordneten Reihen von Leistungs-Bauelementen (T) mit jeweils zu der Zwischenkreis-Leiterplatte (ZP) hingewandter, jedoch weggewinkelter Vorderseite und zu der Haupt-Kühlfläche (KF) hingewandter und zugewinkelter rückseitiger Einzel-Kühlfläche (TF).

6. Halbleiter-Schaltungsanordnung nach zumindest einem der Ansprüche 4 bzw. 5, enthaltend:
- ein je reihenförmiger Anordnung für sämtliche Leistungs-Bauelemente (T) gemeinsames Wärmeleitstück (WL) und/oder Andrückstück (AS).

7. Halbleiter-Schaltungsanordnung nach zumindest einem der Ansprüche 3-6, enthaltend:
- eine toleranzausgleichende erste Zwischenschicht (ZW1), insbesondere eine elastische Elastomer-Schicht, zwischen den gegenseitigen Andruckflächen des Andruckstückes (AS) einerseits und den Leistungs-Bauelementen (T) andererseits.

8. Halbleiter-Schaltungsanordnung nach zumindest einem der Ansprüche 1-7, enthaltend:
- eine gegenseitig fixierende bzw. wärmeleitende, insbesondere zwischengegossene, zweite Zwischenschicht (ZW2) zwischen den Zwischenkreis-Bauelementen (L;C) einerseits und der Haupt-Kühlfläche (KF) andererseits.

9. Halbleiter-Schaltungsanordnung nach zumindest einem der Ansprüche 1-8, enthaltend:
- eine Steuer-Leiterplatte (SP) mit einer in Funktionsverbindung mit den Leistungs-Bauteilen (T) stehenden Ansteuereinheit im Abstand zu der dem Abstandsraum abgewandten Seite der Zwischenkreis-Leiterplatte (ZP).

## Claims

1. Semiconductor circuit arrangement, specifically a high-current converter with low dc-link voltage, containing
- a dc-link circuit board (ZP), specifically a multilayer circuit board;
- a main cooling surface (KF) spaced apart from and parallel to the dc-link circuit board (ZP);
- passive dc-link components (C;L) and active discrete power components (T) with individual integrated backside cooling surface (TF);
- an arrangement of the passive dc-link components (C;L) and of the active discrete power components (T) in the interspace (A) between the dc-link circuit board (ZP) and the main cooling surface (KF);
- an arrangement of the dc-link components (C;L) and/or of the power components (T) with contacting ends (P) oriented towards and in contact with the dc-link circuit board (ZP);
- an arrangement of the power components (T) wherein an individual cooling surface (TF) is angled obliquely towards the main cooling surface (KF) in each case;
- a heat transfer at least between the individual cooling surfaces (TF) on the one hand and the main cooling surface (KF) on the other via a heat-conducting piece (WL) in heat-conducting contact with the individual cooling surfaces (TF) and the main cooling surface (KF);
- a pressure-contact piece (AS) with which the power components (T) can be pressed with their individual cooling surface (TF) vertically in the direction of pressure against the heat-conducting piece (WL).

2. Semiconductor circuit arrangement according to Claim 1, containing:
- electrical contacting of the dc-link components (C;L) and/or of the power components (T) with the dc-link circuit board (ZP) on its surface facing away from the interspace (A).

3. Semiconductor circuit arrangement according to Claim 1 and/or 2, containing:
- an arrangement of the dc-link circuit board (ZP) above the main cooling surface (KF);

4. Semiconductor circuit arrangement according to at least one of Claims 1-3, containing:
- an alternately in-line arrangement of the dc-link components (C;L) on the one hand and the power elements (T) on the other hand in the interspace (A) between the dc-link circuit board (ZP) and main cooling surface (KF) respectively.

5. Semiconductor circuit arrangement according to at least one of Claims 1-4, containing:
- an arrangement of two rows of power components (T), each pair disposed in a V-shape, with the front side in each case turned towards but angled away from the dc-link circuit board (ZP), and the individual backside cooling surface (TF) turned towards the main cooling surface (KF) and angled towards it.

6. Semiconductor circuit arrangement according to at least one of Claims 4 or 5, containing:
- an in-line arrangement in each case for the heat-conducting piece (WL) and/or pressure-contact piece (AS) common to all the power components (T).

7. Semiconductor circuit arrangement according to at least one of Claims 3-6, containing:
- a tolerance-compensating first intermediate layer (ZW1), specifically an elastic elastomer layer, between the mutual contact surfaces of the pressure-contact piece (AS) on the one hand and the power components (T) on the other.

8. Semiconductor circuit arrangement according to at least one of Claims 1-7, containing:
- a mutually fixed or heat-conducting, specifically moulded-in, second intermediate layer (ZW2) between the dc-link components (L;C) on the one hand and the main cooling surface (KF) on the other.

9. Semiconductor circuit arrangement according to at least one of Claims 1-8, containing:
- a control circuit board (SP) with a drive unit functionally linked to the power components (T) and spaced apart from the side of the dc-link circuit board (ZP) facing away from the interspace.

## Revendications

1. Agencement de circuit à semi-conducteurs, notamment convertisseur à courant fort à basse tension de circuit intermédiaire, comprenant :
- une carte de circuit imprimé de circuit intermédiaire (ZP), plus précisément une carte de circuit imprimé multicouches;
- une surface de refroidissement principale (KF) espacée parallèlement de la carte de circuit imprimé de circuit intermédiaire (ZP);
- des composants passifs de circuit intermédiaire (C;L) et des composants de puissance discrets actifs (T) ayant une surface de refroidissement individuelle arrière intégrée (TF);
- un agencement des composants passifs de circuit intermédiaire (C;L) et des composants de puissance discrets actifs (T) dans l'espace (A) entre la carte de circuit imprimé de circuit intermédiaire (ZP) et la surface de refroidissement principale (KF);
- un agencement des composants de circuit intermédiaire (C;L) et/ou des composants de puissance (T) avec des extrémités de contact (P) dirigées vers la carte de circuit imprimé de circuit intermédiaire (ZP) et en contact avec celle-ci ;
- un agencement des composants de puissance (T) dans le sens d'une surface de refroidissement individuelle (TF) respectivement placée inclinée par rapport à la surface de refroidissement principale (KF);
- un transfert de chaleur au moins entre les surfaces de refroidissement individuelles (TF) d'une part et la surface de refroidissement principale (KF) d'autre part au moyen d'un élément de dissipation thermique (WL) qui se trouve en contact de conduction thermique avec les surfaces de refroidissement individuelles (TF) et la surface de refroidissement principale (KF);
- un élément de serrage (AS) avec lequel les composants de puissance (T) peuvent être serrés contre l'élément de dissipation thermique (WL) avec leurs surfaces de refroidissement individuelles (TF) dans le sens d'une pression dirigée perpendiculairement à la surface de refroidissement principale (KF).

2. Agencement de circuit à semi-conducteurs selon la revendication 1, comprenant :
- une mise en contact électrique des composants de circuit intermédiaire (C;L) et/ou des composants de puissance (T) avec la carte de circuit imprimé de circuit intermédiaire (ZP), du côté de sa surface opposée à l'espace (A).

3. Agencement de circuit à semi-conducteurs selon la revendication 1 et/ou 2, comprenant :
- un agencement de la carte de circuit imprimé de circuit intermédiaire (ZP) au-dessus de la surface de refroidissement principale (KF).

4. Agencement de circuit à semi-conducteurs selon l'une au moins des revendications 1 à 3, comprenant :
- un agencement alterné sous forme de rangées des composants de circuit intermédiaire (C;L) d'une part et des composants de puissance (T) d'autre part dans l'espace (A) entre la carte de circuit imprimé de circuit intermédiaire (ZP) et la surface de refroidissement principale (KF).

5. Agencement de circuit à semi-conducteurs selon l'une au moins des revendications 1 à 4, comprenant :
- un agencement de respectivement deux rangées disposées en V l'une par rapport à l'autre de composants de puissance (T) muni chacun d'une face avant tournée vers la carte de circuit imprimé de circuit intermédiaire (ZP), mais inclinée vers l'autre côté et d'une surface de refroidissement individuelle (TF) arrière inclinée vers la surface de refroidissement principale (KF).

6. Agencement de circuit à semi-conducteurs selon l'une au moins des revendications 4 ou 5, comprenant :
- un agencement respectivement sous forme de rangée d'un élément de dissipation thermique (WL) et/ou d'un élément de serrage (AS) commun à tous les composants de puissance (T).

7. Agencement de circuit à semi-conducteurs selon l'une au moins des revendications 3 à 6, comprenant :
- une première couche intermédiaire (ZW1) de compensation des tolérances, plus précisément une couche en élastomère élastique entre les surfaces de serrage réciproques de l'élément de serrage (AS) d'une part et les composants de puissance (T) d'autre part.

8. Agencement de circuit à semi-conducteurs selon l'une au moins des revendications 1 à 7, comprenant :
- une deuxième couche intermédiaire (ZW2) à adhérence sur ses deux faces et conductrice de chaleur, en particulier intercalée par moulage, entre les composants de circuit intermédiaire (L;C) d'une part et la surface de refroidissement principale (KF) d'autre part.

9. Agencement de circuit à semi-conducteurs selon l'une au moins des revendications 1 à 8, comprenant :
- une carte de circuit imprimé de commande (SP) munie d'un module de commande qui se trouve en liaison fonctionnelle avec les composants de puissance (T) à une certaine distance de la face de la carte de circuit imprimé de circuit intermédiaire (ZP) qui est à l'opposé de l'espace.
